# DEMANDE DE BREVET EUROPEEN

(11) **EP 3 726 568 A1**
(43) Date de publication de la demande: **21.10.2020**
(21) Numéro de dépôt: 20170260.2
(22) Date de dépôt: 17.04.2020
(51) Int. Cl.: H01L 21/36

(54) **PROCEDE DE FABRICATION D'OXYDE DE GALLIUM DE TYPE P PAR DOPAGE INTRINSEQUE, SOUS FORME DE FILM MINCE ET SON UTILISATION**

(30) Priorité: 17.04.2019 FR 1904117
(71) Demandeur: Hosseini-Teherani, Ferechteh, 91400 Orsay (FR); Rogers, David J., 10300 Sainte Savine (FR); Bove, Philippe Henri, 91190 Gif sur Yvette (FR); Sandana, Vinod Eric, 95140 Garges-Lès-Gonesse (FR)
(72) Inventeur: Hosseini-Teherani, Ferechteh, 91400 Orsay (FR); Rogers, David J., 10300 Sainte Savine (FR); Bove, Philippe Henri, 91190 Gif sur Yvette (FR); Sandana, Vinod Eric, 95140 Garges-Lès-Gonesse (FR)
(74) Mandataire: Derrien, Murielle

(57) **Abrégé**

L'invention concerne un procédé de fabrication de Ga2O3 à large bande interdite de type p. Le procédé est caractérisé en ce que l'on fait croitre l'oxyde de gallium, par une technique de croissance, sur un substrat en agissant seulement sur la variation de la stoechiométrie en oxygène, et en contrôlant la température de la croissance, la puissance du gaz oxydant utilisé ou la vitesse de dépôt, etc...de telle sorte que l'oxyde de gallium de type p est généré par un dopage intrinsèque à base de défauts, sans aucune impureté ajouté. Le procédé comprend en outre une étape d'utilisation d'une couche tampon ladite couche tampon peut être n'importe quel matériau oxyde ou nitrure, ainsi qu'une étape de post-recuit afin de renforcer l'activation du comportement de l'oxyde de gallium de type p. L'invention concerne, en outre, le film mince de Ga2O3 de type p développé sur un substrat, obtenu selon le procédé, ainsi que l'utilisation dudit film mince dans des jonctions p-n à base de Ga2O3 et son utilisation dans des domaines tels que l'électrode transparente de type p, les photodétecteurs UVC, les commutateurs haute fréquence, l'électronique résistante à la radiation (e.g. bétavoltaiques), l'électronique de puissance, l'électronique de haut de fréquence, l'électronique à haute température, ainsi que dans les domaines de thermoélectrique ou dans électronique spatial.

## Description

### Domaine technique

La présente invention a pour objet un procédé de croissance de Ga₂O₃ (oxyde de gallium) de type p. Plus particulièrement l'invention a pour objet un procédé de fabrication Ga₂O₃ (phase α, β, ε, ou k) de type p par dopage intrinsèque, sans ajouter d'impureté, ainsi que le film mince obtenu par ledit procédé et l'utilisation du film mince de Ga₂O₃ de type p dans des jonction p-n, dans par exemple, l'électronique de puissance, l'électronique haute fréquence, la thermoélectrique et les photodétecteurs UVC, etc..

### Technique antérieure

L'oxyde de gallium (III) est un composé inorganique de type sesquioxyde et avec la formule Ga₂O₃. Il existe sous la forme de plusieurs polymorphes. On recense cinq phases cristallines α, β, γ, δ et ε (et sa variante k). La phase la plus stable est la phase β à la fois chimiquement et thermiquement, avec un point de fusion autour de 1900 °C.

L'oxyde de gallium (III) a été étudié dans l'utilisation de lasers, de luminophores et de matériaux luminescents. Le Ga₂O₃ est utilisé dans les capteurs de gaz comme luminophore et peut être utilisé comme revêtement diélectrique pour les cellules solaires. Cet oxyde stable a également montré un potentiel en tant que oxyde conducteur de type transparent aux ultraviolets profonds et en tant que transistor dans l'électronique de puissance.

L'oxyde de gallium peut être synthétisé par différentes techniques, dont les conditions de mise en œuvre gouvernent les propriétés des couches. Les propriétés physiques des matériaux élaborés en couches minces sont régies par les paramètres généraux de croissance, la nature et l'orientation du substrat, mais aussi par la technique de croissance mise en œuvre.

L'oxyde de gallium β-Ga₂O₃ est intrinsèquement un matériau diélectrique. Mais il montre aussi, sous certaines conditions de fabrication des propriétés semi-conductrices de type n avec des valeurs de résistivité électrique pouvant atteindre 10⁻² Ω.cm, qui peuvent s'expliquer par l'existence de lacunes en oxygène ou encore par un dopage extrinsèque (avec impureté telle que le silicium ou l'étain).

La conductivité des cristaux de β-Ga₂O₃ peut être contrôlée en modifiant l'environnement gazeux ou par dopage. La conductivité peut être augmentée avec la diminution de la teneur en oxygène. Il est suggéré que la présence de l'hydrogène joue un rôle aussi dans la conductivité électrique observée dans la β-Ga₂O₃ dopée. Par ailleurs, le dopage avec d'autres éléments affecte également la conductivité électrique et la concentration d'électrons libres des cristaux β- Ga₂O₃. Par exemple, les éléments du groupe IV tels que Si, Ge et Sn se substituent à l'élément 'Ga', ou encore, les éléments du groupe VII tels que CL et F se substituent à l'élément 'O' et agissent comme donneurs peu profonds.

La demande de brevet US 20080038906 décrit une méthode pour produire un film mince Ga₂O₃ de type p et une jonction de type p-n du film mince de Ga₂O₃. La méthode consiste à produire dans une première étape un film mince de Ga₂O₃ en réduisant la densité de lacunes d'oxygène et dans une deuxième étape la formation d'un film mince de β-Ga₂O₃ de type p en dopant le Ga₂O₃ avec un accepteur. L'accepteur utilisé dans ce procédé est le Magnésium, Mg.

La demande de brevet US20120304918 décrit un procédé de croissance monocristalline de β-Ga₂O₃, un dispositif électroluminescent de Ga₂O₃ et son procédé de fabrication. Plus particulièrement, il divulgue un procédé de croissance d'un film mince de type p de β-Ga₂O₃ en remplaçant Ga, dans le film mince, par un dopant de type p choisi parmi H, Li, Na, K, Rb, Cs, Fr, Be, Mg, Ca, Sr, Ba, Ra, Mn, Fe, Co, Ni, Pd, Cu, Ag, Au, Zn, Cd, Hg, TI et Pb.

Nous savons d'après l'état de l'art que l'oxyde de gallium (de phase α, β, ε, ou k) est nativement du type n. Nous savons également que le dopage de type n peut être augmenté en ajoutant des impuretés qui agissent comme des donneurs peu profonds (les exemples typiques sont le germanium, l'étain, le fluor, le chlore ou le silicium). Nous avons remarqué dans les documents ci-dessus que le β-Ga₂O₃ peut être dopé de type p par un dopage extrinsèque en introduisant des impuretés qui peuvent agir comme accepteurs peu profonds avant ou après la croissance. Or l'ajout de l'impureté, nécessite l'introduction d'un troisième élément dopant dans le Ga₂O₃ dans un niveau contrôlé et de manière reproductible, ce qui constitue une complication importante de la procédure de fabrication de Ga₂O₃ de type p. En outre, ledit dopant peut être mobile dans la structure cristalline de Ga₂O₃ de sorte à modifier les propriétés électriques au fil du temps. Une telle diffusion de dopant peut également être provoquée avec les températures plus élevées, comme on peut s'y attendre dans les appareils électroniques à haute température, les thermoélectriques, les appareils électroniques de puissance, l'électronique spatiale et d'autres applications, y compris certains imprévus qui peuvent tester la robustesse thermique.

### Résumé de l'invention

A cette fin l'invention propose la réalisation du dopage p d'oxyde de gallium sans addition d'impuretés. Cette approche de dopage intrinsèque avec des défauts représente une simplification significative par rapport à un dopage extrinsèque avec impuretés, ce qui signifie également qu'il est moins couteux. En outre, l'oxyde de gallium de type p selon cette approche est plus résistant à la température de sorte que des défauts n'évoluent qu'à plus haute température.

De façon précise l'invention à pour objet un procédé de fabrication d'oxyde de gallium, Ga₂O₃ (de phase α, β, ε, ou k) à large bande interdite de type p caractérisé en ce que l'on fait croitre l'oxyde de gallium sur un substrat, par une technique de croissance connue, en agissant seulement sur la variation de la stoechiométrie en oxygène, à travers le contrôle de la température de croissance, la nature/pression du gaz oxydant, la puissance de la cellule à plasma (créant les atomes d'oxygène radicalaires) ou la vitesse de dépôt, etc.. de telle sorte que l'oxyde de gallium de type p est généré par un dopage intrinsèque à base de défauts, sans aucune impureté ajoutée.

Selon une variante de l'invention, le substrat peut être le saphir Al₂O₃ avec une orientation en 'a' ou 'c' ou 'r' ou 'm' ou le titanate de strontium de formule SrTiO₃, l'oxyde de magnésium MgO, l'oxyde de Nickel NiO, l'oxyde de Cuivre (CuO ou Cu₂O) le Silicium Si, l'oxyde de gallium Ga-O, le SiC-4H, le SiC-6H, l'oxyde de zinc ZnO, le nitrure de gallium GaN le nitrure d'aluminium AIN, le verre, le quartz, un métal, le graphène, le graphite, oxyde de graphène ou les polymère, etc...

Selon des variantes de l'invention, la croissance d'oxyde de gallium sur un substrat peut être effectuée par les dépôts en phase liquide ou sol-gel, dépôt physique en phase vapeur PVD, par évaporation sous vide, évaporation par faisceau d'électron en phase vapeur, pulvérisation cathodique, ablation laser pulsé PLD, épitaxie par jet moléculaire MBE, dépôt chimique en phase vapeur CVD, MOCVD, dépôt de monocouches atomiques ALD, etc..

Selon des caractéristiques particulières la température de la croissance peut être maintenue constante ou variable, la plage de la modification de la température de croissance est entre 300 °C et 1500 °C et la pression partielle du dépôt peut être constante ou variable (selon le taux/profil de dopage souhaité) entre 10⁻² et 10⁻¹¹ Torr.

Selon des caractéristiques particulières, l'atmosphère oxydante peut être de l'oxygène moléculaire gazeux ou de la vapeur d'eau ou l'ozone gazeux ou le monoxyde d'azote NO gazeux ou le dioxyde d'azote NO₂ gazeux ou l'oxygène atomique provenant d'une source de plasma.

Selon des caractéristiques particulières, le procédé comprend l'utilisation d'une couche tampon (choisie en fonction des paramètres du matériau comme la structure cristalline, les paramètres de maille, l'orientation cristalline, l'épaisseur de la couche, la morphologie de surface et/ou la taille des grains cristallins souhaités), ladite couche tampon peut être n'importe quel matériau oxyde ou nitrure. L'épaisseur de la couche tampon peut aller de 1 nm à 500 nm.
elon des caractéristiques particulières, le procédé comprend une étape de post-recuit thermique in situ ou ex situ afin de renforcer l'activation du comportement de l'oxyde de gallium de type p. Ce recuit peut durer entre 10 ns et 10 heures.

Selon des variantes, le recuit peut être thermique ou par laser ou par lampe. Le recuit thermique peut être à température fixe ou variable. La température de recuit est comprise entre 200 °C et 1500 °C. L'atmosphère pour le recuit peut être l'oxygène moléculaire, le NO₂, le NO, l'ozone, le N₂ , l'Ar, le Kr, ou l'air.

Selon une variante de l'invention, le recuit par laser peut être effectué avec de la lumière ultraviolette avec une longueur d'onde inférieure à celle correspondant à l'énergie de la bande interdite de Ga₂O₃ (c'est-à-dire une énergie ∼> 5eV). La durée d'exposition peut être entre 10ns et 1s. La densité d'énergie de la source lumineuse est située entre 1 mJ / cm² et 1 kJ / cm².

Selon une variante de l'invention, le recuit par lampe peut être effectuée avec une lampe halogène ou des lampes primaires ou des lampes à décharges, avec la température de recuit pouvant atteindre 1500°C. La densité d'énergie fournie peut dépasser 100 J/cm2 et durer entre 100 µs et 300s.

L'invention concerne en outre un film mince de Ga₂O₃ (α, β, ε, ou k) de type p avec une épaisseur entre 1 nm et 10 micromètres, caractérisé en ce qu'il est obtenu par la croissance de l'oxyde de gallium sur un substrat, par un dopage intrinsèque de type p, a base de défauts, sans aucune impureté intentionnellement ajoutée selon le procédé décrit ci-dessus.

L'invention concerne également l'utilisation d'un film mince de Ga₂O₃ (de phase α, β, ε, ou k) de type p obtenu par le procédé ci-dessus dans des jonctions p-n à base de Ga₂O₃.

L'invention concerne en outre, l'utilisation d'un film mince de Ga₂O₃ de type p obtenu par le procédé ci-dessus comme les électrodes transparentes de type p ou dans les photodetecteurs UVC ou dans les commutateurs hautes fréquences.

L'invention concerne aussi, l'utilisation d'un film mince de Ga₂O₃ de type p obtenu par le procédé ci-dessus dans l'électroniques à haute température, l'électronique de puissance, l'électronique haute fréquence et/ou dans le domaine thermoélectrique et/ou dans l'électronique spatiale.

### Description des modes de réalisation

Pour mettre en œuvre le procédé de croissance d'oxyde de gallium de type p, on peut utiliser, par exemple, une technique de dépôt de couches minces sous vide telle que l'épitaxie par jet moléculaire, la pulvérisation cathodique, l'ablation laser pulsé (ce qui est souvent appelé « pulsed laser déposition » ou PLD), ou par dépôt chimique en phase vapeur CVD, ou par MOCVD, ou par dépôt en phase liquide ou par sol-gel, ou par dépôt de monocouches atomiques ALD, etc.

Le substrat peut être en saphir (Al₂O₃, SrTiO3 l'oxyde de magnésium MgO, le Silicium Si, l'oxyde de gallium GaO, le SiC-4H, le SiC-6H, l'oxyde de zinc, ZnO, l'oxyde de Nickel NiO, l'oxyde de Cuivre (CuO ou Cu₂O) le nitrure de gallium GaN le nitrure d'aluminium AIN, le verre, le quartz ou le métal, le graphène, le graphite, oxyde de graphène ou les polymère, etc.... Le substrat est nettoyé et porté à une température élevé afin de dégazer. L'atmosphère oxydante peut être de l'oxygène moléculaire gazeuxou de la vapeur d'eau ou l'ozone gazeux ou le monoxyde d'azote NO gazeux ou le dioxyde d'azote NO2 gazeux ou l'oxygène atomique provenant d'une source de plasma. La pression atmosphérique en oxygène peut être constante ou variable entre 10⁻² et 10⁻¹¹ Torr afin de varier le taux et/ou le profil de dopage.

Par ailleurs, la température de croissance peut être maintenue constante ou variable, La plage de la température de croissance peut être entre 30 ° C et 1500 °C selon le taux de dopage souhaité et la nature du substrat (une température plus élevée réduit le taux de dopage). L'épaisseur du film peut aller de 1 nm à 10 micromètres. Une vitesse typique de croissance est environ 0,5 nm par minute.

Une couche tampon peut être utilisée pour augmenter la concentration et / ou la mobilité des porteurs de type p dans la couche Ga₂O₃ obtenue, ou encore pour augmenter la conductivité de ladite couche. Une épaisseur de ladite couche tampon peut aller de 1 nm à 500 nm. Afin de renforcer l'activation du comportement de type p, une étape de post-recuit peut être utilisée. Le recuit peut être thermique ou par laser ou encore par lampe. Dans le cas de recuit thermique la température peut rester fixe ou encore elle peut être variable, cette température est comprise entre 600°C et 1500° C. Le recuit thermique peut durer entre 10 minutes et 10 heures. L'atmosphère pour le recuit peut être l'oxygène moléculaire, le NO₂, le NO, l'ozone, le N₂, l'Ar, le Kr, ou l'air.

Le recuit par laser (continu ou pulsé) peut être effectué avec de la lumière ultraviolette avec une longueur d'onde inférieure à celle correspondant à l'énergie de la bande interdite de Ga₂O₃ (c'est-à-dire une énergie ~> 5eV). La durée d'exposition est variable et peut être entre 10ns et 1s. La densité d'énergie de la source lumineuse pourrait peut être 1 mJ / cm² et 1 kJ / cm².

Dans le cas de recuit par lampe la source est souvent composée de lampe de type halogène. Cette technologie est assez flexible en termes de montée en température et permet donc de contrôler la dynamique thermique de recuit. La température de recuit peut atteindre jusqu'à 1500°C. Des lampes primaires et des lampes à décharges peuvent aussi être utilisées pour recuit. L'avantage d'utiliser des lampes à décharge est la rapidité dans la montée en température. L'utilisation de ces lampes à décharge permet donc de diminuer la durée de recuit afin de réduire la diffusion transitoire des dopants. Le pic de température peut monter jusqu'à 1500 °C, la densité d'énergie fournie peut dépasser 100 J/cm2 et durer entre 100 µs et 30 s.

La croissance d'une couche mince de Ga₂O₃ de type p dans l'état de technique se réalise en présence d'un dopant de type p, de telle sorte que le Ga dans la couche de Ga₂O₃ est remplacé par ledit dopant. Pour la mise en œuvre du procédé de la présente invention Ga₂O₃ n'est pas en présence d'un dopant, le procédé est basé seulement sur la variation stoechiométrie en oxygène et le contrôle des conditions de croissance, par exemple la température de la croissance ou la puissance de gaz oxydante utilisé ou la vitesse de dépôt, etc... Avec le procédé de l'invention, on génère une couche de Ga₂O₃ de type p par un dopage intrinsèque à base de défauts et sans introduction d'une impureté dopant. Ce procédé est considérablement simplifié par rapport aux méthodes de croissance de l'état de la technique, ce qui signifie également qu'il est moins coûteux. En outre, la couche Ga₂O₃ de type p ainsi obtenue sera plus résistante aux températures extrêmes et aux radiations dans la mesure où la structure des défauts évolue moins à haute température que la distribution des impuretés.

Nous allons décrire ci-après un exemple de procédé de fabrication de Ga₂O₃ de type p selon la présente invention. Pour cela le Ga₂O₃ de type p a été développé sur un substrat saphir d'orientation c, c-Al2O3, par dépôt au laser pulsé (ce qui est souvent appelé « ablation laser » ou « pulsed laser déposition » (PLD)). Le substrat est nettoyé par immersion séquentielle dans l'acétone, l'éthanol et l'eau désionisé suivi par un séchage sous flux d'azote moléculaire et porté à une température de 700°C ±150°C pendant 30 minutes sous vide (<10⁻⁶ Torr) afin de dégazer. Le dépôt est effectué avec un laser excimère KrF (248nm) ou ArF (193nm) LPX 200 de la société Coherent (avec une fréquence de répétition 10Hz ± 8Hz et une durée de pulse de 30ns ±15ns) et une source cible solide à base d'une poudre de Ga₂O₃ (stœchiométrique d'une pureté 4N ou plus) ou GaO qui est comprimée et frittée. Le faisceau est focalise sur une cible afin de donner une densité de puissance d'environ 10⁸ W/cm² ± 5x10⁷ W/cm²).

Une couverture uniforme de la plaquette de c-saphir, de 2 pouces de diamètre, a été obtenue en utilisant un balayage optique du faisceau laser incident sur la cible. La température du substrat c-Al₂O₃ a été maintenue entre 380°C et 550° C et la pression d'oxygène pendant la croissance est de 10⁻⁴ Torr. Nous obtenons ainsi les couches de ε/k-Ga₂O₃ d'une épaisseur environ 300 nm. · La vitesse de croissance est d'environ 5 nm/min. Les couches ont ensuite été recuites à l'air dans un four tubulaire à 700°C ±100°C pendant 30 minutes afin d'activer la concentration en porteurs de type p. Le substrat Al₂O₃, sur lequel cette couche de beta Ga₂ O₃ de type p est développée, a l'avantage d'être moins cher par rapport au substrat de Ga₂O₃ massif qui est typiquement utilisé dans l'état de la technique, et en plus, le substrat saphir se trouve dans des formats plus large et à plus grande volume de production. Ce qui rend le procédé de fabrication de beta Ga₂O₃ de type p encore moins coûteux et plus adapté à une industrialisation rapide.

L'invention concerne également, les films mince de Ga₂O₃ (α, β, ε, ou k) de type p obtenus par le procédé décrit précédemment. Les films obtenus ont différents épaisseurs entre 1nm et 10 micromètres selon le temps de dépôt.

L'invention concerne, en outre l'utilisation du film mince Ga₂O₃ (α, β, ε, ou k) de type p obtenu par le procédé ci-dessus, dans des jonctions P-N, dans lesquelles la région n est constituée de Ga₂O₃ de type n et la région p est constituée de Ga₂O₃ de type p, obtenus selon le procédé de la présente invention par un dopage intrinsèque.

L'invention concerne, en outre, l'utilisation du film mince Ga₂O₃ de type p dans les photodétecteurs UVC, les électrodes transparentes de type p, l'électronique résistante aux radiations (exemple : beta voltaïques), les appareils électroniques à haute température, dans les domaines de la thermoélectrique, de l'électronique de puissance, de l'électronique de haut de fréquence, de l'électronique spatiale et d'autres domaines et applications. A titre exemple, les performances d'un transistor à effet de champ (FET), réalisé dans un film mince bêta oxyde de gallium sur isolant, ont été présentées, dans l'article « High Performance Depletion/Enhancement-Mode-Ga2O3 on Insulator (GOOI) Field-effect Transistors » publié dans IEEE Electron Device Letters en janvier 2017.

Nous savons que la bande interdite ultra-large du matériau Ga₂O₃ (a, b, e ou k) de type p le rend efficace pour la commutation à haute tension et cette efficacité pourrait aider à réduire la consommation d'énergie en remplaçant les commutateurs de puissance qui sont actuellement en silicium.

L'étude et l'analyse structurelle et chimique d'un film de β-Ga₂O₃ de type p obtenu selon le procédé de l'invention ainsi que les propriétés électriques ont été publiés dans l'article « *P-type*-Ga2O3 *oxide: A new perspective for power and optoelectronic devices* » dans Materials today physics.

## Revendications

1. Procédé de fabrication de Ga₂O₃ de phase α, β, ε, ou k de type p à large bande interdite **caractérisé en ce que** l'on fait croitre l'oxyde de gallium, par une technique de croissance, sur un substrat en agissant seulement sur la variation de la stoechiométrie en oxygène, et en contrôlant la température de la croissance, la puissance de gaz oxydante utilisé ou la vitesse de dépôt, de telle sorte que l'oxyde de gallium de type p est généré par un dopage intrinsèque à base de défauts, sans aucun impureté ajouté.

2. Procédé de fabrication d'oxyde de gallium de Ga₂O₃ de phase α, β, ε, ou k de type p selon la revendication 1, dans lequel le substrat peut être le saphir Al₂O ₃ avec une orientation en 'a' ou 'c' ou 'r' ou 'm' ou le titanate de strontium SrTiO₃, l'oxyde de magnésium MgO, le Silicium Si, l'oxyde de gallium Ga-O, le SiC-4H, le SiC-6H, l'oxyde de zinc ZnO, l'oxyde de Nickel NiO, l'oxyde de Cuivre (CuO ou Cu₂O) le nitrure de gallium GaN le nitrure d'aluminium AIN, le verre, le quartz, un métal, le graphène, le graphite, oxyde de graphène ou les polymère, etc..

3. Procédé de fabrication d'oxyde de gallium, Ga₂O₃ de phase α, β, ε, ou k de type p selon l'une des revendications précédentes, dans lequel la température de la croissance peut être maintenu constant ou variable entre 300 °C et 1500 °C et dans lequel la pression partiel de gaz oxydante peut être (constante ou variable selon le taux/profil de dopage souhaité) entre 10⁻² et 10⁻¹¹ Torr.

4. Procédé de fabrication d'oxyde de gallium, Ga₂O₃ de phase α, β, ε, ou k de type p selon l'une des revendications précédentes dans lequel l'atmosphère oxydante peut être de l'oxygène moléculaire gazeux ou de la vapeur d'eau ou l'ozone gazeux ou le monoxyde d'azote NO gazeux ou le dioxyde d'azote NO₂ gazeux ou l'oxygène atomique provenant d'une source de plasma.

5. Procédé de fabrication d'oxyde de gallium, Ga₂O₃ de phase α, β, ε, ou k de type p selon l'une des revendications précédentes **caractérisé en ce que** le procédé comprend en outre une étape d'utilisation d'une couche tampon, ladite couche tampon peut être n'importe quel matériau oxyde ou nitrure et que l'épaisseur de cette couche tampon peut varier entre 1 nm à 500 nm.

6. Procédé de fabrication d'oxyde de gallium, Ga₂O₃ de phase α, β, ε, ou k de type p selon l'une des revendications précédentes **caractérisé en ce qu'**il comprend une étape de post-recuit afin de renforcer l'activation du comportement de l'oxyde de gallium de type p, et que le recuit peut durer entre 10 minutes et 10 heures.

7. Procédé de fabrication d'oxyde de gallium, Ga₂O₃ de phase α, β, ε, ou k de type p selon la revendication 6 dans lequel le recuit peut être thermique ou par laser ou par lampe et dans lequel le recuit thermique peut être à température fixe ou variable entre 600° C et 1500 °C et que l"atmosphère pour le recuit peut être l'oxygène moléculaire, le NO₂, le NO, l'ozone, le N₂, l'Ar, le Kr, ou l'air.

8. Procédé fabrication d'oxyde de gallium, Ga₂O₃ de phase α, β, ε, ou k de type p selon la revendication 7 dans lequel le recuit par laser peut être effectué avec de la lumière ultraviolette (continu ou pulsé) avec une longueur d'onde inférieure à celle correspondant à l'énergie, d'environ 5 eV, de la bande interdite de Ga₂O₃, dans lequel la durée d'exposition est entre 10ns et 1s, et dans lequel la densité d'énergie de la source lumineuse est entre 1 mJ / cm² et 1 kJ / cm².

9. Procédé de fabrication d'oxyde de gallium, Ga₂O₃ de phase α, β, ε, ou k de type p selon la revendication 7 dans lequel le recuit par lampe peut être effectué avec une lampe halogène ou des lampes primaires ou des lampes à décharges, dans lequel la température de recuit peut atteindre jusqu'à 1500°C et dans lequel la densité d'énergie fournie peut dépasser 100 J/cm2 et durer entre 100 µs et 300s.

10. Film mince de Ga₂O₃ de phase α, β, ε, ou k de type p avec une épaisseur entre 1 nm et 10 micromètres **caractérisé en ce qu'**il est obtenu par la croissance de l'oxyde de gallium sur un substrat, par un dopage intrinsèque, a base de défauts, sans aucun impureté intentionnellement ajouté selon l'une des revendications 1 à 9 du procédé de fabrication.

11. Utilisation d'un film mince de Ga₂O₃ de phase α, β, ε, ou k de type p, obtenu par le procédé selon l'une des revendications 1 à 9, dans des jonctions p-n à base de Ga₂O₃.

12. Utilisation d'un film mince de Ga₂O₃ de phase α, β, ε, ou k de type p, obtenu par le procédé selon l'une des revendications 1 à 9, comme une électrode transparente de type p ou dans les photodétecteurs UVC, dans les commutateurs haute fréquence, dans les appareils électroniques à haute température et/ou dans l'électronique de puissance et/ou thermoélectrique ou dans l'électronique résistante à la radiation (e.g. bétavoltaiques) ou dans l'électronique spatial.
